# EUROPÄISCHE PATENTSCHRIFT

(11) **EP 1 856 957 B1**
(45) Veröffentlichungstag und Bekanntmachung des Hinweises auf die Patenterteilung: **31.07.2013**
(21) Anmeldenummer: 06708113.3
(22) Anmeldetag: 08.02.2006
(51) Int. Cl.: H05K 9/00

(54) **FUNKTIONSVORRICHTUNG MIT EINER ELEKTRISCHEN BAUEINHEIT**
OPERATIONAL DEVICE PROVIDED WITH AN ELECTRIC MODULAR UNIT
DISPOSITIF FONCTIONNEL EQUIPE D'UNE UNITE STRUCTURALE ELECTRIQUE

(30) Priorität: 23.02.2005 DE 102005008175
(43) Veröffentlichungstag der Anmeldung: 21.11.2007
(73) Patentinhaber: ROBERT BOSCH GMBH, 70442 Stuttgart (DE)
(72) Erfinder: KRESPACH, Andreas, 71272 Renningen (DE); JAUCH, Thomas, 70806 Kornwestheim (DE)
(86) Internationale Anmeldenummer: PCT/EP2006/050767
(87) Internationale Veröffentlichungsnummer: WO 2006/089839

(56) Entgegenhaltungen:
- EP-A1- 1 399 004
- EP-B1- 1 102 109
- US-A- 5 380 955
- US-B1- 6 273 499
- US-B1- 6 344 978

## Beschreibung

### Stand der Technik

Die Erfindung betrifft eine Funktionsvorrichtung, insbesondere für ein Kraftfahrzeug, mit einer eine Abschirmung gegen Störabstrahlung aufweisenden elektrischen Baueinheit, wobei die Abschirmung ein die Baueinheit umfassendes Abschirmgehäuse aufweist und die Baueinheit mit einem in das Abschirmgehäuse durch einen Gehäusedurchlass eintretenden elektrischen Leiter kontaktiert ist.

Eine solche Funktionsvorrichtung ist beispielsweise in EP 1399 004 A1 als Vorschaltgerät für eine zum Beispiel als Suchlicht eines Fahrzeuges verwendete Hochspannungsentladungslampe offenbart. Das Vorschaltgerät umfasst unter anderem ein Verteilerschienengehäuse als Montageelement, ein Unterteil sowie eine Abdeckung. Mehrere das Vorschaltgerät mit der Hochspannungsentladungslampe verbindende Ausgangskabel sind durch eine Abschirmhülse hindurchgeführt, die mittels einer Schelle und einer Schraube an dem Verteilerschienengehäuse, und zwar auf einer Kabeldurchführung des Verteilerschienengehäuses, befestigt ist. Bei dieser Funktionsvorrichtung sind die Abdeckung, das Unterteil und die Abschirmhülse geerdet. Dabei weist die Abschirmhülse mittels der Anordnung aus Hülse, Schelle und Schraube eine konstruktiv sehr aufwendige Erdung auf.

Aus der US-A-5 380 955 ist eine Vorrichtung zur Durchführung einer Flachbandleitung durch eine Wand einer versiegelten Kammer bekannt. Hierbei weist die Flachbandleitung an ihrer Ober- und Unterseite eine Schicht aus Kupfer zur Abschirmung der Flachbandleitung auf. Der Kupferschirm ist mit einem Kupferkeil kontaktiert, der die Flachbandleitung umgibt und der mittels eines aus Lot bestehenden Elementes von einem Flansch aufgenommen wird. Die Vorrichtung kann mithilfe des Flansches derart über einer Öffnung in der Wand der Kammer befestigt werden, dass eine Durchführung der Flachbandleitung durch die Wand erfolgt.

Darüber hinaus ist allgemein ein elektromagnetisch entstörtes Kabel als elektrische Zuführung für ein elektronisches Gerät in einem Kraftfahrzeug bekannt, wobei das Kabel eine zumindest teilweise Ummantelung mit Einlagerungen, die elektromagnetische Störstrahlungen absorbieren sollen, aus einem Absorbermaterial aufweist.

Der Erfindung liegt die Aufgabe zugrunde, eine Funktionsvorrichtung der eingangs genannten Art mit vereinfachtem Aufbau und wirkungsvoller Abschirmung anzugeben.

Diese Aufgabe wird durch die Merkmalskombination des Anspruchsatz 1 gelöst.

### Vorteile der Erfindung

Die erfindungsgemäße Funktionsvorrichtung kann vorteilhaft zum Beispiel eine Anzeigevorrichtung in einem Kraftfahrzeug aufweisen, wobei die abzuschirmende elektrische Baueinheit ein elektronisches Steuergerät zur Ansteuerung eines Bildschirmes der Anzeigevorrichtung sein kann. Es ist aber beispielsweise auch denkbar, dass die Funktionsvorrichtung ein automatisches oder halbautomatisches - zum Beispiel elektrisch oder elektrohydraulisch schaltbares - Getriebe, vorzugsweise für ein Kraftfahrzeug, umfasst und dass die abzuschirmende elektrische Baueinheit als Steuereinheit für das Getriebe dient. Mit der Erfindung kann der bauliche Aufwand der Funktionsvorrichtung vorteilhaft erheblich vermindert werden. Es ist nicht erforderlich, aufwendige Schellenkonstruktionen oder kostenintensive, abgeschirmte Stecker und/oder Steckverbindungen zur Kontaktierung der Leiterabschirmung des die abzuschirmende elektrische Baueinheit zum Beispiel mit einem außerhalb des Abschirmgehäuses angeordneten Bildschirm kontaktierenden elektrischen Leiters zu verwenden, sondern die Erfindung sieht demgegenüber in einfacher Weise eine direkte Kontaktierung der

Leiterabschirmung über das Abschirmgehäuse vor. Die Leiterabschirmung nutzt zur Kontaktierung somit das Abschirmgehäuse selbst. Dadurch ergibt sich neben einer kostengünstigen Herstellbarkeit der erfindungsgemäßen Funktionsvorrichtung eine besonders hohe Betriebssicherheit der Abschirmung. Der Leiter kann allgemein ein lnformabons- und/oder Signalleiter, insbesondere ein Datenleiter, sein. Vor allem kann die abzuschirmende elektrische Baueinheit, insbesondere elektronische Baueinheit, sehr hohe Frequenzen und/oder Datenraten verarbeiten und eine daraus resultierende theoretische Störabstrahlung in einer Größenordnung aufweisen, die ohne die Erfindung geeignet wäre, weitere Elemente der Funktionsvorrichtung und/oder im Umfeld der Funktionsvorrichtung angeordnete, einem Einfluss der Störabstrahlung unterliegende weitere Einrichtungen in unerwünschter Weise zu beeinflussen, ohne dass diese Beeinflussung mit der Erfindung tatsächlich eintritt; eine vorgenannte Beeinflussung kann mit der erfindungsgemäßen, wirkungsvollen Abschirmung sicher vermieden werden. Der Gehäusedurchlass kann zum Beispiel als Gehäuseausnehmung ausgebildet oder von einem Schlitz zwischen zwei Gehäuseteilen gebildet sein. Aufgrund ihres einfachen Aufbaues, ihrer hohen Betriebssicherheit und ihrer kostengünstigen Herstellbarkeit ist die erfindungsgemäße Funktionsvorrichtung besonders geeignet zur Verwendung in Kraftfahrzeugen. Zudem ist wegen der großen Anzahl in Kraftfahrzeugen regelmäßig eingesetzter elektrischer und elektronischer Systeme eine hocheffektive Abschirmung wie sie mit der Erfindung vorteilhaft erreicht wird hier von besonderer Bedeutung, da Störabstrahlungen in Kraftfahrzeugen unmittelbar unerwünschte Auswirkungen sowohl auf die Verkehrssicherheit im Allgemeinen als auch auf die Sicherheit der Insassen der Kraftfahrzeuge im Speziellen haben können. Mit der erfindungsgemäßen Funktionsvorrichtung auf baulich besonders einfache Weise hohe EMV(=elektromagnetische Verträglichkeit)-Anforderungen erfüllt.

Erfindungsgemäß grenzen an den Gehäusedurchlass ein erstes Abschirmgehäuseteil und ein zweites Abschirmgehäuseteil an, und das erste Abschirmgehäuseteil und das zweite Abschirmgehäuseteil bilden den Leiter und die Leiterabschirmung in dem Gehäusedurchlass einklemmende Klemmelemente. Damit sind für die Kontaktierung der Leiterabschirmung keinerlei zusätzliche Bauteile erforderlich. Sowohl eine Halterung und Fixierung des Leiters in dem Gehäusedurchlass als auch die Kontaktierung der Leiterabschirmung kann vorteilhaft direkt mittels der Klemmung, die durch die - vorzugsweise gegeneinander verspannten - Klemmelemente bewirkt wird, erfolgen. Zur

Verspannung und Klemmung können die Abschirmgehäuseteile vorzugsweise miteinander verschraubt sein.

Gemäß einer vorteilhaften Weiterbildung der Erfindung weist der Leiter eine Flachbandleitung oder einen Flexleiter auf. Eine Flachbandleitung, die regelmäßig einen vieladrigen Aufbau mit nebeneinander, in einer Ebene angeordneten Leitern aufweist, sowie auch ein Flexleiter besitzen den Vorteil, dass jeweils unabhängig voneinander über eine Mehrzahl von einzelnen Leitern elektrische Signale übertragen werden können und gleichzeitig die Flachbandleitung oder der Flexleiter räumlich vergleichsweise freizügig in der Funktionsvorrichtung anordnenbar ist. Ein Flexleiter kann beispielsweise aus Kupferbahnen bestehen, die beidseitig von einer flexiblen Isolationsschicht umgeben sind; ein alternativer Flexleiter kann aber zum Beispiel auch im Sinne einer flexiblen Leiterplatte auf einer elektrisch isolierenden Folie aufgebrachte Leiterbahnen aufweisen.

Grundsätzlich unterliegt die Ausbildung der Leiterabschirmung keinen Einschränkungen. Jedoch erhält man eine kostengünstige Leiterabschirmung, die sich zudem in einfacher Weise mit dem Abschirmgehäuse kontaktieren lässt, wenn gemäß einer anderen vorteilhaften Weiterbildung der Erfindung die Leiterabschirmung einen Metallschirm aufweist.

Dabei wird die Wirksamkeit der Abschirmung bei niedrigen Kosten weiter erhöht, wenn gemäß einer vorteilhaften Weiterbildung der Erfindung der Metallschirm ein Kupferschirm ist.

Besonders betriebssicher und einfach, insbesondere als nieder-impedanter Abschirmkontakt, lässt sich die Leiterabschirmung kontaktieren, wenn gemäß einer anderen vorteilhaften Weiterbildung der Erfindung die Leiterabschirmung mittels einer Klemmkontaktierung mit dem Abschirmgehäuse elektrisch kontaktiert ist. Für eine Klemmkontaktierung eignet sich aufgrund der dann gegebenen großen Klemmfläche und definierbaren Flächenpressung besonders eine Leiterabschirmung einer Flachbandleitung oder eines Flexleiters.

Die Bauteilanzahl der Funktionsvorrichtung wird weiter verringert und der Aufbau der Funktionsvorrichtung außerdem vereinfacht, wenn gemäß einer anderen vorteilhaften

Weiterbildung der Erfindung ein zumindest einen Teil des Abschirmgehäuses als Subgehäuse aufweisendes Vorrichtungsgehäuse vorgesehen ist und das Vorrichtungsgehäuse und das Subgehäuse ein einziges Bauteil bildend miteinander verbunden sind. Das Vorrichtungsgehäuse, das auch die gesamte Funktionsvorrichtung umfassen kann, kann beispielsweise ein Elektrogehäuse oder ein Getriebegehäuse sein. Grundsätzlich kann das Vorrichtungsgehäuse selbst ebenfalls als Abschirmgehäuse ausgebildet sein.

Grundsätzlich kann das Vorrichtungsgehäuse selbst ebenfalls als Abschirmgehäuse ausgebildet sein.

Für eine gute Abschirmung und eine hohe mechanische Haltbarkeit bilden das Vorrichtungsgehäuse und das Subgehäuse gemäß einer vorteilhaften Weiterbildung der Erfindung vorzugsweise ein einziges Spritzgussbauteil oder Druckgussbauteil. Vorrichtungsgehäuse und Abschirmgehäuse sind dann einstückig, ein einziges Bauteil bildend miteinander verbunden und können in einem einzigen Fertigungsschritt hergestellt werden.

Gemäß einer anderen vorteilhaften Weiterbildung der Erfindung weist eine Wandung des Abschirmgehäuses und/oder eine Wandung des Vorrichtungsgehäuses eine Leiterplatte auf, so dass die Bauteilanzahl der Funktionsvorrichtung weiter verringert werden kann. Die Leiterplatte kann dabei über das Abschirmgehäuse hinausgreifen und sowohl eine Wandung des Vorrichtungsgehäuses als auch eine Wandung des Abschirmgehäuses bilden.

Von besonderem Vorteil ist es, wenn gemäß einer Weiterbildung der Erfindung die die Abschirmung aufweisende elektrische Baueinheit auf der Leiterplatte angeordnet ist. Auf diese Weise kann eine andernfalls erforderliche weitere Leiterplatte eingespart werden.

Vorteilhaft kann die Bauteilintegration in der Funktionsvorrichtung weiter erhöht und die Abschirmung zusätzlich verbessert werden, wenn gemäß einer Weiterbildung der Erfindung die Leiterplatte eine Abschirmmassefläche aufweist.

### Zeichnung

Ein Ausführungsbeispiel der Erfindung ist in der Zeichnung schematisiert dargestellt und wird nachfolgend näher beschrieben. Es zeigen
- Figur 1: eine Funktionsvorrichtung in perspektivischer Ansicht,
- Figur 2: einen Ausschnitt der Funktionsvorrichtung nach Figur 1 in perspektivischer Ansicht,
- Figur 3: den Ausschnitt der Funktionsvorrichtung nach Figur 2 in einer weiteren perspektivischen Ansicht und
- Figur 4: eine Leiterplatte der Funktionsvorrichtung nach Figuren 1 bis 3.

### Beschreibung des Ausführungsbeispieles

In sämtlichen Figuren sind sich entsprechende Elemente mit gleichen Bezugszeichen versehen.

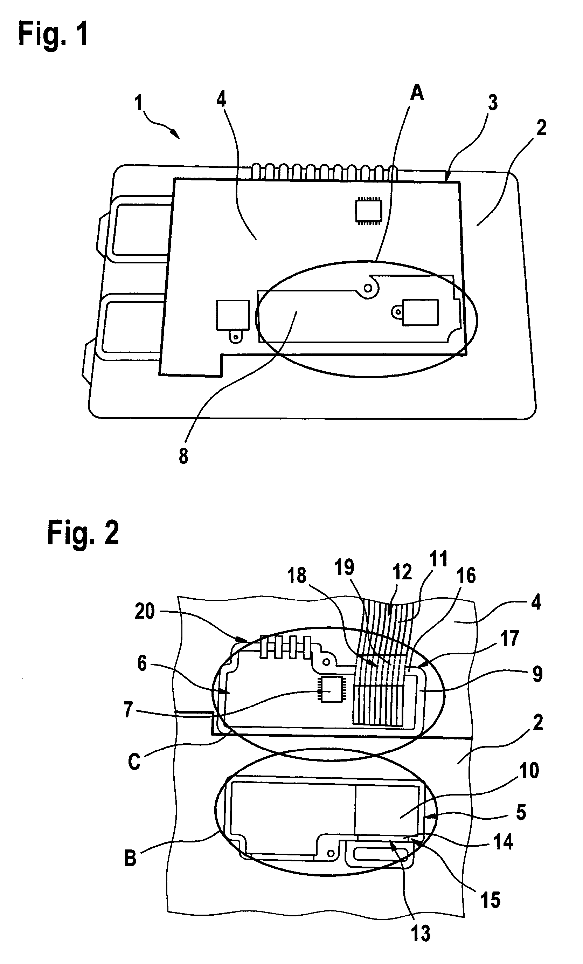

In Figur 1 ist eine Funktionsvorrichtung 1 mit einem Vorrichtungsgehäuse 2 dargestellt. Die Funktionsvorrichtung 1 umfasst eine Ansteuervorrichtung für eine hier nicht weiter dargestellte Anzeige, insbesondere mit einem TFT-Display (= Thin-Film Transistor Display = Dünnschichttransistor-Bildschirm), in einem Kraftfahrzeug. Eine obere Wandung 3 des Vorrichtungsgehäuses 2 weist eine Leiterplatte 4 in Form eines Deckels des Vorrichtungsgehäuses 2 auf. Hervorgehoben ist ein Leiterplattenbereich A mit einer Abschirmmassefläche 8, der eine Leiterplattenoberseite auf einem im Folgenden näher beschriebenen abgeschirmten Schaltungsteil umfasst.

Einen Ausschnitt der Funktionsvorrichtung nach Figur 1 zeigt Figur 2, wobei die einen Deckel des Vorrichtungsgehäuses 2 bildende Leiterplatte 4 das Vorrichtungsgehäuse 2 öffnend hochgeklappt ist. Ein Teilbereich B des Vorrichtungsgehäuses 2 umfasst als Subgehäuse 10 des Vorrichtungsgehäuses 2 einen überwiegenden Teil eines Abschirmgehäuses 5. Geschlossen wird das Abschirmgehäuse 5 mit der Leiterplatte 4. Das Vorrichtungsgehäuse 2 und das Subgehäuse 10 sind ein einziges Bauteil bildend miteinander verbunden; sie formieren einstückig ein einziges Gussbauteil aus einem Metall.

Ein Teilbereich C auf der Leiterplatte 4 umfasst den oben genannten abgeschirmten Schaltungsteil, der eine elektrische Baueinheit 6, insbesondere zur Bildgenerierung und Graphikbearbeitung für die oben genannte Anzeige, aufweist. Die elektrische Baueinheit 6 weist unter anderem einen Wandlerbaustein 7 auf. Ein Kontaktrahmen 9 auf der Leiterplatte 4 dient einer Kontaktierung des Subgehäuses 10 mit der Leiterplatte 4. Die Leiterplatte 4 bildet nicht nur einen Teil der oberen Wandung 3 (siehe Figur 1) des Vorrichtungsgehäuses 2, sondern die Leiterplatte 4 bildet im geschlossenen Zustand des Vorrichtungsgehäuses 2, in dem auch das Abschirmgehäuse 5 geschlossen ist, zudem gleichzeitig die obere Wandung des Abschirmgehäuses 5.

Die abgeschirmte elektrische Baueinheit 6 auf der Leiterplatte 4 ist mit einem als Flachbandleitung 11 ausgebildeten elektrischen Leiter 12 kontaktiert. Die Flachbandleitung 11, eine Datenleitung, die insbesondere Signale zur Ansteuerung der oben genannten Anzeige (und - in einem alternativen Ausführungsbeispiel - gegebenenfalls Ansteuersignale für einen motorischen Drehantrieb der Anzeige) überträgt, tritt durch einen Gehäusedurchlass 13 in das Abschirmgehäuse 5 ein. Der Gehäusedurchlass 13 wird einerseits von einem Wandungsabschnitt 14 des Subgehäuses 10 als ein erstes Abschirmgehäuseteil 15 und andererseits von einem Kontaktrahmenabschnitt 16 des Kontaktrahmens 9 als ein zweites Abschirmgehäuseteil 17 begrenzt.

Im Bereich des Gehäusedurchlasses 13 weist die Flachbandleitung 11 eine Leiterabschirmung 18 mit einem Metallschirm 19 auf. Der Metallschirm 19 ist in diesem Ausführungsbeispiel ein Kupferschirm. Die Leiterabschirmung 18 ist direkt mit dem Abschirmgehäuse 5 elektrisch kontaktiert, und zwar mittels einer Klemmkontaktierung im geschlossenen Zustand (vergleiche Figur 1) des Abschirmgehäuses 5, wobei die Leiterplatte 4 aus ihrer in Figur 2 dargestellten, hochgeklappten Stellung auf das Vorrichtungsgehäuse 2 zurückgeklappt ist.

In dieser zurückgeklappten Stellung der Leiterplatte 4 klemmen das erste Abschirmgehäuseteil 15 und das zweite Abschirmgehäuseteil 17 als Klemmelemente die Flachbandleitung 11 mit der Leiterabschirmung 18 in dem Gehäusedurchlass 13 ein. Die Leiterabschirmung 18 wird dabei unmittelbar mit dem Abschirmgehäuse 5 kontaktiert.

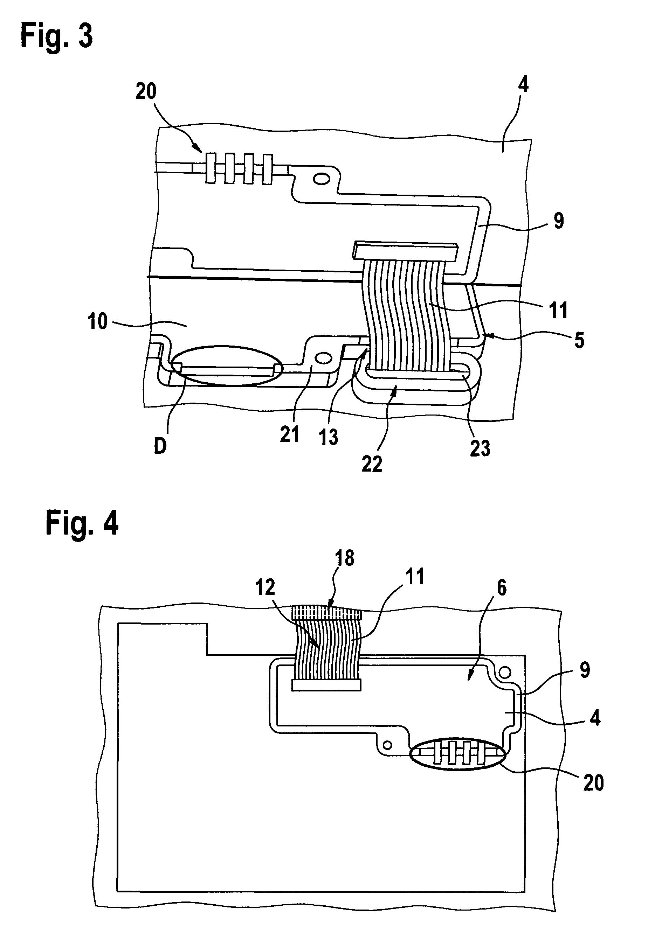

Auf der Leiterplatte 4 befindet sich weiterhin eine Filterbank 20, die in einem in Figur 3 hervorgehobenen Durchgangsbereich D des Abschirmgehäuses 5 angeordnet ist. Die Filterbank 20 ist für Versorgungsleitungen vorgesehen, um potentielle Störungen aus dem abgeschirmten Bereich innerhalb des Abschirmgehäuses 5 nicht in andere Bereiche der Leiterplatte 4 hinauszuziehen.

Ferner sind Figur 3 der Kontaktrahmen 9 auf der Leiterplatte 4 und eine mit dem Kontaktrahmen 9 korrespondierende Wandungskontaktfläche 21 des Subgehäuses 10 zu entnehmen. Der Kontaktrahmen 9, der einen elektrischen Massering darstellt, und die Wandungskontaktfläche 21 bilden im geschlossenen Zustand des Abschirmgehäuses 5 aneinander anliegende elektrische Kontaktflächen.

Dem Gehäusedurchlass 13 für die Flachbandleitung 11 nachgeschaltet ist ein mit dem Subgehäuse 10 ein einziges Bauteil bildend verbundener Ausgang 22 des Vorrichtungsgehäuses 2. Durch den Ausgang 22 verlässt die Flachbandleitung 11 das Vorrichtungsgehäuse 2. Der Ausgang 22 ist mit einer an der Flachbandleitung 11 anliegenden Gummidichtung 23 versehen, so dass das Vorrichtungsgehäuse 2 zudem staubdicht verschlossen ist.

Figur 4 zeigt die Leiterplatte 4 in einer Draufsicht, in welcher der Kontaktrahmen 9, der die abgeschirmte elektrische Baueinheit 6 umgreift und zur Masseanbindung des Abschirmgehäuses dient, einschließlich der Filterbank 20 zu erkennen ist. Der als Flachbandleitung 11 ausgebildete Leiter 12 mit der Leiterabschirmung 18, die zum Beispiel eine eine Isolierung der Flachbandleitung nach außen durchbrechende Kontaktbandage zur Schirmanbindung der Flachbandleitung aufweisen kann und bei der es sich hier um einen einfachen Kontaktstreifen zur Schirmanbindung der Flachbandleitung handeln kann, verbindet die abgeschirmte Baueinheit 6 mit der nicht dargestellten Anzeige.

## Patentansprüche

1. Funktionsvorrichtung, insbesondere für ein Kraftfahrzeug, mit einer eine Abschirmung gegen Störabstrahlung aufweisenden elektrischen Baueinheit, wobei die Abschirmung ein die Baueinheit umfassendes Abschirmgehäuse aufweist und die Baueinheit mit einem in das Abschirmgehäuse durch einen Gehäusedurchlass eintretenden elektrischen Leiter kontaktiert ist, **dadurch gekennzeichnet, dass** der Leiter (12) im Bereich des Gehäusedurchlasses (13) eine Leiterabschirmung (18) aufweist, dass die Leiterabschirmung (18) unmittelbar mit dem Abschirmgehäuse (5) elektrisch kontaktiert ist, dass an den Gehäusedurchlass (13) ein erstes Abschirmgehäuseteil (15) und ein zweites Abschirmgehäuseteil (17) angrenzen und dass das erste Abschirmgehäuseteil (15) und das zweite Abschirmgehäuseteil (17) den Leiter (12) und die Leiterabschirmung (18) in dem Gehäusedurchlass (13) einklemmende Klemmelemente bilden.

2. Funktionsvorrichtung nach Anspruch 1, **dadurch gekennzeichnet, dass** der Leiter (12) eine Flachbandleitung (11) oder einen Flexleiter aufweist.

3. Funktionsvorrichtung nach Anspruch 1 oder 2, **dadurch gekennzeichnet, dass** die Leiterabschirmung (18) einen Metallschirm (19) aufweist.

4. Funktionsvorrichtung nach Anspruch 3, **dadurch gekennzeichnet, dass** der Metallschirm (19) ein Kupferschirm ist.

5. Funktionsvorrichtung nach einem der vorhergehenden Ansprüche, **dadurch gekennzeichnet, dass** die Leiterabschirmung (18) mittels einer Klemmkontaktierung mit dem Abschirmgehäuse (5) elektrisch kontaktiert ist.

6. Funktionsvorrichtung nach einem der vorhergehenden Ansprüche, **dadurch gekennzeichnet, dass** ein zumindest einen Teil des Abschirmgehäuses (5) als Subgehäuse (10) aufweisendes Vorrichtungsgehäuse (2) vorgesehen ist und dass das Vorrichtungsgehäuse (2) und das Subgehäuse (10) ein einziges Bauteil bildend miteinander verbunden sind.

7. Funktionsvorrichtung nach Anspruch 6, **dadurch gekennzeichnet, dass** das Vorrichtungsgehäuse (2) und das Subgehäuse (10) ein einziges Spritzgussbauteil oder Druckgussbauteil bilden.

8. Funktionsvorrichtung nach einem der vorhergehenden Ansprüche, **dadurch gekennzeichnet, dass** eine Wandung des Abschirmgehäuses (5) und/oder eine Wandung (3) des Vorrichtungsgehäuses (2) eine Leiterplatte (4) aufweist.

9. Funktionsvorrichtung nach Anspruch 8, **dadurch gekennzeichnet, dass** die die Abschirmung aufweisende elektrische Baueinheit (6) auf der Leiterplatte (4) angeordnet ist.

10. Funktionsvorrichtung nach Anspruch 8 oder 9, **dadurch gekennzeichnet, dass** die Leiterplatte (4) eine Abschirmmassefläche (8) aufweist.

## Claims

1. Functional apparatus, in particular for a motor vehicle, having an electrical unit which has a screening means against interference radiation, wherein the screening means has a screening housing which encloses the unit, and an electrical conductor which enters the screening housing through a housing passage makes contact with the unit, **characterized in that** the conductor (12) has a conductor screening means (18) in the region of the housing passage (13), **in that** the screening housing (5) makes direct electrical contact with the conductor screening means (18), **in that** a first screening housing part (15) and a second screening housing part (17) adjoin the housing passage (13), and **in that** the first screening housing part (15) and the second screening housing part (17) form clamping elements which clamp the conductor (12) and the conductor screening means (18) in the housing passage (13).

2. Functional apparatus according to Claim 1, **characterized in that** the conductor (12) has a ribbon cable (11) or a flexible conductor.

3. Functional apparatus according to Claim 1 or 2, **characterized in that** the conductor screening means (18) has a metal screen (19).

4. Functional apparatus according to Claim 3, **characterized in that** the metal screen (19) is a copper screen.

5. Functional apparatus according to one of the preceding claims, **characterized in that** the screening housing (5) makes electrical contact with the conductor screening means (18) by means of a clamping contact-making means.

6. Functional apparatus according to one of the preceding claims, **characterized in that** an apparatus housing (2) which has at least one part of the screening housing (5) as a sub-housing (10) is provided, and **in that** the apparatus housing (2) and the sub-housing (10) are connected to one another so as to form a single component.

7. Functional apparatus according to Claim 6, **characterized in that** the apparatus housing (2) and the sub-housing (10) form a single injection-moulded component or die-cast component.

8. Functional apparatus according to one of the preceding claims, **characterized in that** a wall of the screening housing (5) and/or a wall (3) of the apparatus housing (2) have/has a printed circuit board (4).

9. Functional apparatus according to Claim 8, **characterized in that** the electrical unit (6), which has the screening means, is arranged on the printed circuit board (4).

10. Functional apparatus according to Claim 8 or 9, **characterized in that** the printed circuit board (4) has a screening ground surface (8).

## Revendications

1. Dispositif fonctionnel, prévu en particulier pour un véhicule automobile et présentant une unité électrique dotée d'un blindage contre les rayonnements parasites,
le blindage présentant un boîtier de blindage qui englobe l'unité et l'unité étant raccordée par un conducteur électrique qui pénètre dans le boîtier de blindage par un passage ménagé dans le boîtier, **caractérisé en ce que**
le conducteur (12) présente un blindage (18) de conducteur disposé au niveau du passage (13) qui traverse le boîtier,
**en ce que** le blindage (18) du conducteur est raccordé électriquement directement au boîtier de blindage (5),
**en ce qu'**une première partie (15) du boîtier de blindage et une deuxième partie (17) du boîtier de blindage sont adjacentes au passage (13) qui traverse le boîtier et
**en ce que** la première partie (15) du boîtier de blindage et la deuxième partie (17) du boîtier de blindage forment des éléments de serrage qui serrent le conducteur (12) et le blindage (18) du conducteur dans le passage (13) qui traverse le boîtier.

2. Dispositif fonctionnel selon la revendication 1, **caractérisé en ce que** le conducteur (12) présente un conducteur (11) en ruban plat ou un conducteur flexible.

3. Dispositif fonctionnel selon les revendications 1 ou 2, **caractérisé en ce que** le blindage (18) du conducteur présente un blindage métallique (19).

4. Dispositif fonctionnel selon la revendication 3, **caractérisé en ce que** le blindage métallique (19) est un blindage en cuivre.

5. Dispositif fonctionnel selon l'une des revendications précédentes, **caractérisé en ce que** le blindage (18) du conducteur est raccordé électriquement au boîtier (5) de blindage au moyen d'un contact serré.

6. Dispositif fonctionnel selon l'une des revendications précédentes, **caractérisé en ce qu'**au moins une partie du boîtier de blindage (5) est prévue comme boîtier (2) de dispositif qui présente un sous-boîtier (10) et **en ce que** le boîtier (2) de dispositif et le sous-boîtier (10) sont reliés l'un à l'autre pour former un composant intégré.

7. Dispositif fonctionnel selon la revendication 6, **caractérisé en ce que** le boîtier (2) du dispositif et le sous-boîtier (10) forment une unique pièce moulée par injection ou un composant moulé sous pression.

8. Dispositif fonctionnel selon l'une des revendications précédentes, **caractérisé en ce qu'**une paroi du boîtier de blindage (5) et/ou une paroi (3) du boîtier de dispositif (2) présentent une carte de circuit (4).

9. Dispositif fonctionnel selon la revendication 8, **caractérisé en ce que** l'unité électrique (6) qui présente le blindage est disposée sur la carte de circuit (4).

10. Dispositif fonctionnel selon les revendications 8 ou 9, **caractérisé en ce que** la carte de circuit (4) présente une surface (8) en pâte de blindage.
